# EUROPEAN PATENT SPECIFICATION

(11) **EP 2 432 019 B1**
(45) Date of publication and mention of the grant of the patent: **15.04.2015**
(21) Application number: 11180411.8
(22) Date of filing: 07.09.2011
(51) Int. Cl.: H01L 27/146

(54) **Imaging device and imaging apparatus**
Abbildungsgerät und Abbildungsvorrichtung
Dispositif d'imagerie et appareil d'imagerie

(30) Priority: 15.09.2010 JP 2010206850
(43) Date of publication of application: 21.03.2012
(73) Proprietor: Sony Corporation, Tokyo 108-0075 (JP)
(72) Inventor: Yokogawa, Sozo, Minato-ku, Tokyo 108-0075 (JP)
(74) Representative: DeVile, Jonathan Mark

(56) References cited:
- WO-A1-2009/011439
- WO-A1-2009/112174
- WO-A1-2010/073543
- WO-A2-2008/085385
- WO-A2-2009/106316
- US-A1- 2009 323 060

## Description

The present disclosure relates to an imaging device and an imaging apparatus.

In electronic devices that image an object, such as digital still cameras, camcorders, or cameras of portable information terminals, solid-state image sensing devices of CCD (Charge Coupled Device) type or CMOS (Complementary Metal Oxide Semiconductor) type have been mainly employed. These solid-state image sensing devices convert photons entering respective pixels having light sensitivity into electrons or holes by photoelectric conversion and accumulate them as signal charge, and convert the amounts of charge into analog or digital data and output them to the outside of the devices. Then, two-dimensional or three-dimensional images based on the digital data are recorded and the recorded images are reproduced.

Generally, the solid-state image sensing device has sensitivity in a specific electromagnetic wavelength band. An organic molecular material may be rarely used for the CCD or CMOS solid-state image sensing device in a visible wavelength range, however, the device is typically made based on silicon. The silicon-based solid-state image sensing device has sensitivity to a wavelength shorter than that of near infrared rays (about 1.1 µm) due to the band gap of silicon. The silicon has a characteristic that the absorption coefficient per unit thickness becomes smaller for the longer wavelength in the visible wavelength to the near infrared wavelength range, and short-wavelength light (blue) is mainly absorbed in the shallow part of silicon, specifically, at the depth of about 0.2 µm. By contrast, long-wavelength light (red) is not sufficiently absorbed unless the thickness (depth) is 2 to 3 µm or more.

On the other hand, the pixel size is getting smaller and smaller from various factors of increase in the number of pixels with the higher resolution of the solid-state image sensing devices, downsizing of camera modules, reduction of power consumption, reduction of manufacturing unit cost, etc. Recently, the typical size of single pixel has already been a micro pixel having an aperture of about 1.4 µm x 1.4 µm. That is, in the micro pixel, the thickness in the depth direction is larger than the planar aperture size of the pixel. In other words, the pixel has a structure with an aspect ratio larger in the depth direction relative to the planar size. As a result, there is a significant risk of mixing of oblique incident light components in adjacent pixels, and a critical issue of reduction in color reproducibility due to color mixing.

In a CMOS solid-state image sensing device that has recently and rapidly increased its market share as a solid-state image sensing device in place of the CCD solid-state image sensing device, about two or three signal wiring layers are typically provided in the upper part of apertures of photoelectric conversion devices. The case of the pixel structure called front side illumination (FSI) is equal to a structure having well-shaped apertures between the signal wiring lines. Accordingly, the non-negligible components of incident light are reflected or scattered by the wiring layers and the effective aperture ratio becomes lower as the pixel size becomes smaller.

As a technology to break the situation, a back side illumination (BSI) structure is regarded as being effective. In the back side illumination structure, since light is radiated from the silicon rear surface, the incident light efficiently reaches the photoelectric conversion devices without being reflected or scattered by metal wiring lines, and an extremely highly sensitive image sensor may be realized.

For example, various methods of manufacturing image sensing devices having the back side illumination structure have been disclosed in Patent Documents 1 to 4 (JP-A-2005-268738, JP-A-2005-353631, JP-A-2006-54263, and JP-A-2006-80457).

However, the back side illumination sensor has a problem specific to the back side structure. In order to absorb red or near infrared wavelength light, the thickness of the silicon substrate of at least 2 to 3 µm is necessary, and, on the other hand, the aperture size of the single pixel is often the micro pixel of 1 to 2 µm. Accordingly, oblique incident light components are photoelectrically converted in device isolation regions between pixels, the charge of them is accumulated as charge in photodiode parts of the adjacent pixels, and the components consequently become color mixing components. These components cause deterioration of image quality.

On this account, Patent Document 5 (JP-A-2009-65098) has disclosed a method of improving light blocking performance by employing a pixel structure in which a light blocking member is embedded between pixels as an example of measures.

On the other hand, a problem that some of the long-wavelength components of red and near infrared ray is transmitted through the silicon layer as a photoelectric conversion part, and the transmitted components are reflected on an interface between the sensor bottom surface and an insulating film (an interface between a silicon oxide film layer and a nitride film layer) and color mixing to the adjacent pixels occurs remains as an unsolved problem. Under the situation, to reduce influence of color mixing due to miniaturization of the pixel size and improve image quality, it is important to improve light absorption efficiency per unit thickness to efficiently photoelectrically converting the light of long-wavelength components even in the shallow part of silicon, and provide a pixel structure for reducing the reflection on the interface between the silicon and the insulating film.

Recently, a method of applying a conductor structure in which micro conductor particles are two-dimensionally provided at predetermined periodic intervals as a color filter of a solid-state image sensing device or utilizing the structure for the higher sensitivity of the solid-state image sensing device has been proposed.

Here, first, the response when light is radiated on the micro conductor particle will be qualitatively and generally explained.

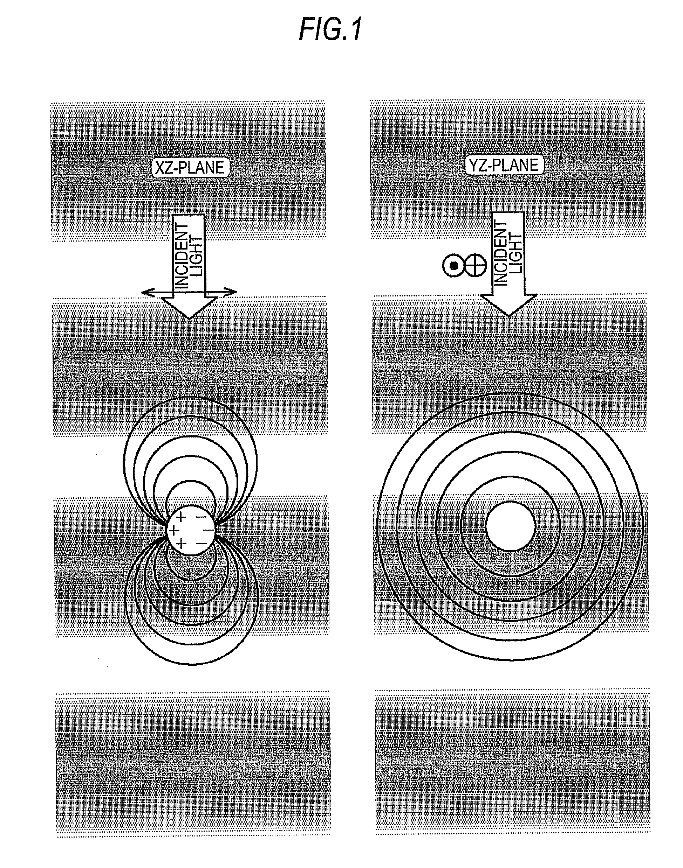

Fig. 1 shows a state in which incident light linearly-polarized along the X-axis is radiated from the upside in the Z-axis direction to the micro conductor particle.

On the left side of Fig. 1, a sectional view along the XZ-plane is shown, and the incident light vibrates within a surface in parallel to the XZ-plane. Further, on the right side of Fig. 1, a sectional view along the YZ-plane is shown, and the incident light vibrates within a surface perpendicular to the YZ-plane.

Here, since the light is electromagnetic wave, in the micro conductor particle to which the incident light has been radiated, a state in which an electromagnetic field due to polarization of the metal particle in response to the incident light and the incident light are coupled (localized plasmon) is produced. Further, when the micro conductor particle is sufficiently smaller than the light wavelength, the local plasmon behaves like electric dipole. As described above, since the incident light (incident electromagnetic wave) is linearly-polarized light along the X-axis, the dipole radiation describing a figure of eight is generated on the XZ-plane, and a concentric electromagnetic radiation field is generated on the YZ-plane as shown in Fig. 1.

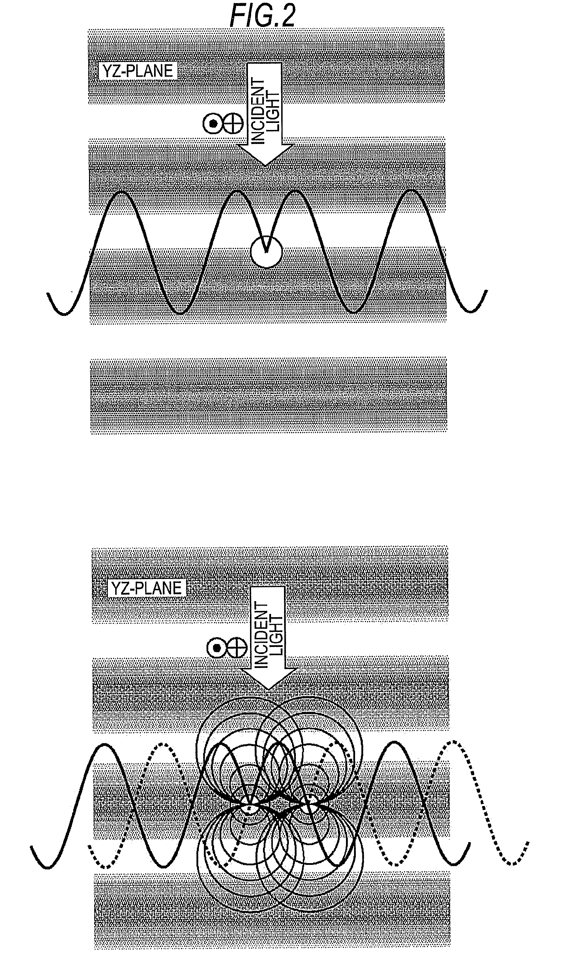

Next, referring to Fig. 2, a state in which incident light is radiated to the micro conductor particles arranged at equal intervals on a two-dimensional plane will be explained.

On the upper side of Fig. 2, a state in which dipole radiation radiated from a single micro conductor particle spreads on the YZ-plane is schematically shown. In this case, the micro conductor particle is singular, and the wavefront concentrically spreads around the micro conductor particle.

On the lower side of Fig. 2, a state in which incident light is radiated to the micro conductor particles arranged at an interval of about a half wavelength of the incident light. In the case where the micro conductor particles are provided in the fashion, interference of electromagnetic waves occurs between the adjacent micro conductor particles. That is, the incident light entering from the upside may be regarded to be in the same phase between the adjacent micro conductor particles, and the dipole radiations radiated by the respective micro conductor particles are nearly in the same phase between the adjacent micro conductor particles. On the other hand, the interval between the micro conductor particles is about a half wavelength, and the dipole radiations radiated by the respective micro conductor particles have a phase difference of 180 degrees within the XY-plane.

Specifically, in Fig. 2, the phase of the electromagnetic wave from the right micro conductor particle is shown by a solid line and the phase of the electromagnetic wave from the left micro conductor particle is shown by a dotted line. As a result of interference of these electromagnetic waves, the radiation fields to the XY-plane are opposite in phase and cancelled out. Therefore, when the conductor structure in which micro conductor particles are arranged at equal intervals on a two-dimensional plane is macroscopically seen, electromagnetic wave having directionality in the vertical direction is radiated.

Recently, various reports have been made regarding the conductor structures.

For example, in Non-Patent Document 1 (Ebbesen, T. W. et al., Nature, Volume 391, Issue 6668, pp. 667-669, 1998), it has been reported that, light is radiated to a conductor structure having a hole array shape in which periodic apertures (holes) are arranged at sub-wavelength intervals on a metal thin film having a plasma frequency in an ultraviolet wavelength range such as silver (Ag), aluminum (AI), or gold (Au), or an island array shape having a sub-wavelength periodic structure such as a dot or island-shaped structure, special light response characteristics such as abnormal transmission due to the property and structure of the conductor thin film is exhibited.

Further, in Non-Patent Document 2 (P. B. Catrysse & B. A. Wandell, J. Opt. Soc. Am. A, Vol.20, No. 12, pp. 2293-2306, 2003), it has been reported that a conductor structure functions as a color filter that selectively transmits a specific wavelength by varying an aperture diameter or aperture diameter interval of a hole array shape or a fine particle interval of an island array shape. Furthermore, in Non-Patent Documents 3 and 4 (Salomon, L. et al., Physical Review Letters, vol. 86, Issue 6, pp. 1110-1113, 2001, and Krishnan, A. et al., Optics Communications, Volume 200, Issue 1-6, pp. 1-7, 2001), it has been suggested that amplified near-field light exists near a conductor structure and its electric field intensity is amplified several digits larger than that of normal propagating light.

In addition, Patent Documents 6 to 8 (JP-A-2006-210620, JP-A-2008-177191, and International Publication No. 2008/082569 Pamphlet) have disclosed using a conductor structure as a color filter of a solid-state image sensing device because these conductor structures may be applied as color filters. Further, Patent Documents 9 and 10 (JP-A-2009-147326 and JP-A-2009-38352) have disclosed a method of improving light absorption efficiency per unit thickness and providing higher sensitivity to the solid-state image sensing device by providing a two-dimensional periodic structure of conductor fine particle on the upper surface of the photodiodes.

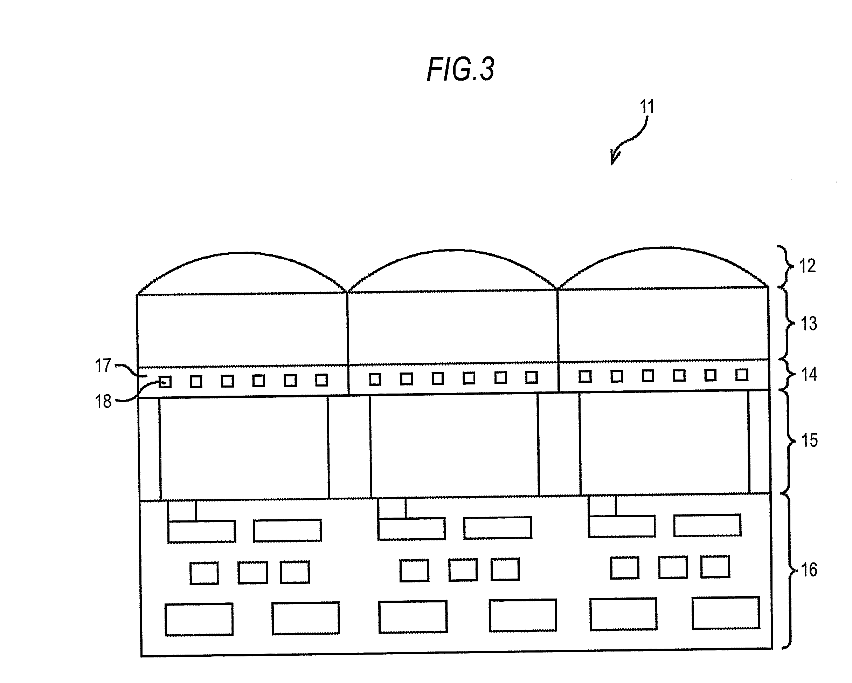

Here, Fig. 3 shows a configuration example of a solid-state image sensing device having a conductor structure.

As shown in Fig. 3, a solid-state image sensing device 11 includes an on-chip micro lens 12, a color filter layer 13, a conductor structure layer 14, a photodiode layer 15, and a signal wiring layer 16 stacked sequentially from the upside.

For example, the conductor structure layer 14 has a structure (island array structure) in which islands 18 as micro conductor particles made of a conductor material such as aluminum or silver are two-dimensionally arranged at sub-wavelength intervals within a dielectric layer 17 made of a dielectric material. As shown in Fig. 3, the conductor structure layer 14 has a single-layer structure in which only one micro particle layer having the two-dimensionally arranged islands 18 is formed.

Note that, as the conductor structure layer 14, a hole array structure formed by inverting an island array structure, i.e., a structure in which holes are arranged in a thin film made of a conductor material may be employed.

In the solid-state image sensing device 11 having the above described configuration, the conductor structure layer 14 may be used as a color filter by optimizing the intervals of the islands 18 (or holes) of the conductor structure layer 14. Note that, when the conductor structure layer 14 is used as a color filter, the color filter layer 13 containing organic molecules or pigments may be omitted.

Further, in the solid-state image sensing device 11, higher sensitivity may be realized by improving the absorption efficiency per unit thickness of the silicon substrate using near-field light existing near the conductor structure layer 14.

As described above, in a solid-state image sensing device, higher sensitivity has been realized using the conductor structure layer, but higher performance of the solid-state image sensing device is still desired.

WO 2009/011439 discloses an optical filter that transmits light of the visible light region includes a dielectric substrate; a dielectric layer that is formed on a surface of the dielectric substrate; and a first metal structure group in which a plurality of first metal structures are arranged two-dimensionally in an isolated state in the in-plane direction of the dielectric substrate, that is provided between the dielectric substrate and the dielectric layer, comprising: the first metal structures having first and second lengths in first and second directions orthogonal to each other, which lengths are equal to or less than a first wavelength in the visible light region; and a transmittance of the first wavelength being reduced or a reflectance being increased by surface plasmons induced on a surface of the first metal structures by resonance between light incident on the dielectric substrate or the dielectric layer and the first metal structures.

WO 2009/112174 discloses an integrated polarization sensor comprising a polarization sensor element that has an optoelectronic sensor and a polarizing filter structure. The optoelectronic sensor and the polarizing filter structure are jointly integrated on a semiconductor substrate.

WO 2008/085385 discloses a plasmonic Fabry-Perot filter which includes a first partial mirror and a second partial mirror separated from the first partial mirror by a gap. At least one of the first partial mirror or the second partial mirror includes an integrated plasmonic optical filter array.

US 2009/323060 relates to an optical spectral sensor for determining the spectral information of incident light, in particular in the visible and infrared spectral range, with at least one optoelectronic semiconductor arrangement and at least one metal film, which is surrounded by a dielectric, wherein the metal film has a periodic pattern, wherein the at least one optoelectronic semiconductor arrangement and the at least one patterned metal film are arranged in such a way that light to be detected initially passes through the patterned metal film and then impinges on the optoelectronic semiconductor arrangement, wherein the optical spectral sensor is formed in such a way that the spectral sensitivity is determined essentially by the optical properties of the patterned metal film.

WO 2009/106316 relates to a multi-spectral image sensor having a two-dimensional array of super-pixels, wherein each super-pixel has at least five sensor elements, each comprising a pixel sensor, a filter structure having at least one structured layer made of metal or polycrystalline semi-conductor material, which, in response to the electromagnetic radiation of a wavelength region, results in a higher transmission through the filter structure to the pixel sensor than wavelengths surrounding the wavelength region, wherein the at least five sensor elements are jointly integrated on a semi-conductor substrate and are configured on different wavelength regions in pairs.

Various respective aspects and features of the invention are defined in the appended claims. Combinations of features from the dependent claims may be combined with features of the independent claims as appropriate.

According to the approach described herein, an imaging device and an imaging apparatus having higher performance may be realized.

Embodiments of the invention will now be described with reference to the accompanying drawings, throughout which like parts are referred to by like references, and in which:
Fig. 1 is a diagram for explanation of a response when light is radiated to a micro conductor particle.
Fig. 2 is a diagram for explanation of a response when light is radiated to micro conductor particles arranged at equal intervals on a two-dimensional plane.
Fig. 3 is a block diagram showing a configuration example of a solid-state image sensing device having a conductor structure.
Fig. 4 is a schematic sectional view showing the first embodiment of a solid-state image sensing device according to one embodiment of the present invention.
Fig. 5 is a diagram for explanation of light response characteristics of two micro particle layers of a conductor structure layer.
Fig. 6 shows XY-plane structures in single layers of six kinds of conductor structure layers.
Fig. 7 shows sectional structures of four kinds of conductor structure layers.
Fig. 8 stereoscopically shows positional relationships of respective islands forming the conductor structure layer.
Fig. 9 is a schematic sectional view showing the second embodiment of a solid-state image sensing device according to one embodiment of the present invention.
Fig. 10 is a schematic sectional view showing the third embodiment of a solid-state image sensing device according to one embodiment of the present invention.
Fig. 11 is a schematic sectional view showing the fourth embodiment of a solid-state image sensing device according to one embodiment of the present invention.
Fig. 12 is a schematic sectional view showing the fifth embodiment of a solid-state image sensing device according to one embodiment of the present invention.
Fig. 13 is a schematic sectional view showing the sixth embodiment of a solid-state image sensing device according to one embodiment of the present invention.
Fig. 14 is a block diagram showing a configuration example of an imaging apparatus with the solid-state image sensing device having the conductor structure layer mounted thereon.
Fig. 15 is a block diagram showing a configuration example of a signal indication apparatus with a display panel having the conductor structure layer mounted thereon.
Fig. 16 is a block diagram showing a configuration example of an information communication apparatus with a light signal detection unit having the conductor structure layer mounted thereon.

As below, specific embodiments of the present invention will be explained in detail with reference to the drawings by way of example only.

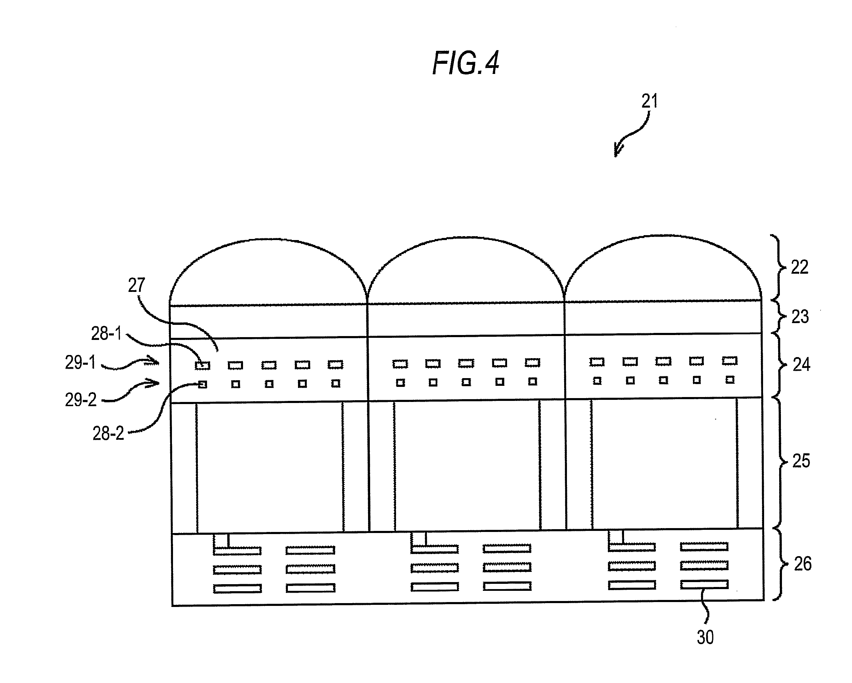

Fig. 4 is a schematic sectional view showing the first embodiment of a solid-state image sensing device according to an embodiment of the present invention.

Fig. 4 shows a configuration example in which a conductor structure layer is mounted on a back side illumination (BSI) CMOS solid-state image sensing device, and a part corresponding to three pixels is extracted and shown.

A solid-state image sensing device 21 includes an on-chip micro lens 22, a color filter layer 23, a conductor structure layer (plasmon resonator layer) 24, a photodiode layer 25, and a signal wiring layer 26 stacked sequentially from the upside.

The on-chip micro lens 22 is an optical device for efficiently guiding light to the photodiode layer 25. The color filter layer 23 contains organic molecules or pigments that selectively transmit visible wavelength components of three primary colors (for example, red, blue, green, or the like).

The conductor structure layer 24 has a structure (island array structure) in which islands 28 as micro conductor particles made of a conductor material such as aluminum or silver are two-dimensionally arranged at sub-wavelength intervals within a dielectric layer 27 made of a dielectric material. In the conductor structure layer 24, unlike the conductor structure layer 14 in Fig. 3, a micro particle layer 29-1 as a layer in which islands 28-1 are two-dimensionally arranged and a micro particle layer 29-2 as a layer in which islands 28-2 are two-dimensionally arranged are formed. That is, while the conductor structure layer 14 has a single-layer structure in which only one micro particle layer is formed, the conductor structure layer 24 has a multilayer structure in which the micro particle layer 29-1 and the micro particle layer 29-2 are formed.

The photodiode layer 25 is a photoelectric conversion layer that converts received light into charge. Further, in the photodiode layer 25, adjacent photodiodes are electrically isolated by an oxide film of STI (Shallow Trench Isolation) or the like or an EDI structure or a CION structure by implantation of impurities.

The signal wiring layer 26 is a layer in which wiring lines 30 for reading charge accumulated in the photodiode layer 25 are provided.

As described above, in the solid-state image sensing device 21, the conductor structure layer 24 is provided on the photodiode layer 25, and, regarding the light focused by the on-chip micro lens 22, a desired wavelength component is selected by the color filter layer 23 and then the transmitted light reaches the conductor structure layer 24.

Here, the periodic structure of the conductor structure layer 24 is optimized for the periods corresponding to the electromagnetic wavelengths detected by respectively corresponding photoelectric conversion devices (set to be optimal in response to periods). For example, in the conductor structure layer 24 corresponding to the pixels for which a red color filter is provided in the color filter layer 23, the micro particle layers 29-1 and 29-2 are formed by two-dimensionally arranging the islands 28-1 and 28-2 at periodic intervals corresponding to the red wavelength (λ = 650 nm). Further, in the conductor structure layer 24 corresponding to the pixels for which a blue color filter and a green color filter are provided in the color filter layer 23, the micro particle layers 29-1 and 29-2 are similarly formed in response to the blue wavelength (λ = 400 nm) and the green wavelength (λ = 550 nm).

Furthermore, the near-field light and the dipole radiation field generated near the conductor structure layer 24 have directionality because the conductor structure layer 24 has the multilayer structure. Thereby, the transmitted light reaching the conductor structure layer 24 is efficiently guided downward (in the propagation direction of electromagnetic wave) and photoelectrically converted by the photodiode layer 25. Then, carriers generated by the photoelectric conversion in the photodiode layer 25 are output as pixel signals to the outside of the solid-state image sensing device 21 via the wiring lines 30 provided in the signal wiring layer 26.

Note that the islands 28-1 and 28-2 as micro particles forming the micro particle layers 29-1 and 29-2 made of an element having a plasma frequency in a shorter wavelength range than visible wavelengths such as aluminum or silver, or compounds containing the elements. Further, in the case where the detection wavelength band is limited to red wavelengths or near infrared rays, metals having plasma frequencies in the visible wavelength range such as gold or copper may be used.

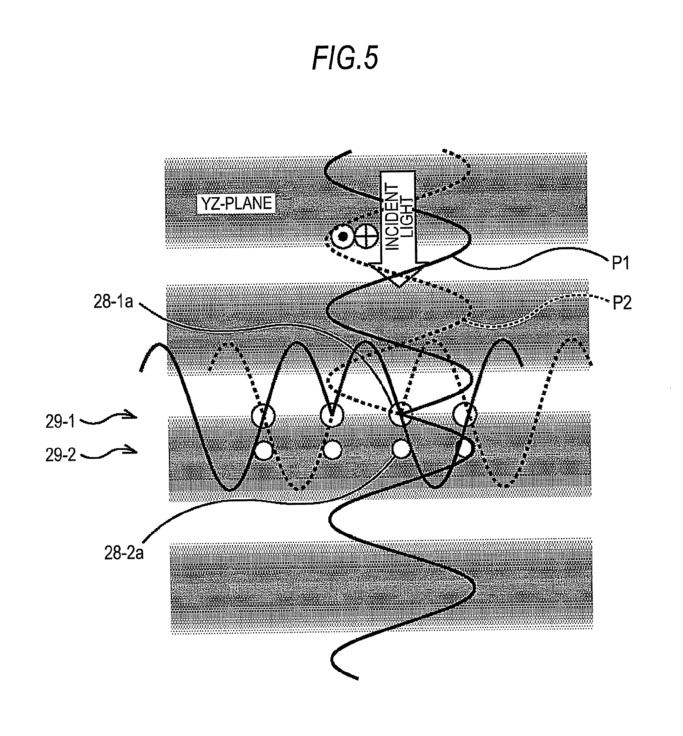

Next, referring to Fig. 5, light response characteristics of the micro particle layer 29-1 and the micro particle layer 29-2 of the conductor structure layer 24 will be explained.

Fig. 5 shows a sectional view along the YZ-plane of the micro particle layer 29-1 and the micro particle layer 29-2, and incident light is radiated from the upside of Fig. 5 along the Z-axis direction and the incident light vibrates within a plane perpendicular to the YZ-plane.

In the conductor structure layer 24, the micro particle layer 29-1 and the micro particle layer 29-2 are placed so that the intervals between them is a 1/4 wavelength of the incident electromagnetic wavelength. That is, the micro particle layer 29-2 is placed offset in the direction in which the light entering from the upside of Fig. 5 travels by the 1/4 wavelength relative to the micro particle layer 29-1.

Here, the explanation will be made by focusing attention on a predetermined island 28-1 a of the islands 28-1 forming the micro particle layer 29-1 and a predetermined island 28-2a of the islands 28-2 forming the micro particle layer 29-2.

Since the interval between the island 28-1 a and the island 28-2a in the traveling direction of the incident electromagnetic wave is the 1/4 wavelength, the radiation from the island 28-2a causes surface localized plasmon resonation with the light out of phase by 90 degrees relative to the radiation from the island 28-1 a. Accordingly, it is considered that the radiation field from the island 28-1 a is similarly out of phase by 90 degrees relative to the radiation field from the island 28-2a.

Therefore, there is a phase difference of 90 degrees between a phase P1 of the electric field from the island 28-1 a and a phase P2 of the electric field from the island 28-2a. Thereby, when the phases P1 and the P2 are superimposed, the radiation components in the direction opposite to the traveling direction of the incident electromagnetic wave (upward in Fig. 5) are canceled out because the phase difference is 180 degrees. On the other hand, the radiation components in the direction along the traveling direction of the incident electromagnetic wave (downward in Fig. 5) are in the same phase and amplified.

Here, it is desirable that the size of the island 28-2 forming the micro particle layer 29-2 is formed slightly smaller than the size of the island 28-1 forming the micro particle layer 29-1. By making the island 28-2 smaller than the island 28-1, the conductance of the island 28-2 may be made smaller than the conductance of the island 28-1.

That is, the light entering from the upper side of the conductor structure layer 24 produces interaction with the micro particle layer 29-1 and generates plasmon, and, when the light caused by the plasmon is radiated to the micro particle layer 29-2, by making the conductance of the micro particle layer 29-2 equal to or less than the conductance of the micro particle layer 29-1, phase inversion can be prevented. As a result, lights propagating in the traveling direction of the incident electromagnetic wave (the direction from top to bottom in Fig. 5) travel in the same phase.

On the other hand, the electromagnetic wave generated in the micro particle layer 29-2 also propagates in the direction of the micro particle layer 29-1. However, since the conductance of the micro particle layer 29-1 is larger than the conductance of the micro particle layer 29-2, when the electromagnetic wave from the micro particle layer 29-2 is radiated to the micro particle layer 29-1, phase inversion occurs. As a result, from a comprehensive standpoint, as described above, the radiation from the island 28-2 causes surface localized plasmon resonation with the light out of phase by 90 degrees relative to the radiation from the island 28-1.

Further, in the case where the conductor structure layer 24 includes three micro particle layers 29-1 to 29-3, it is desirable that the island 28-3 of the third micro particle layer 29-3 is smaller than the island 28-2 of the second micro particle layer 29-2, and, at least, it is necessary that they are nearly in the same size. Similarly, in the case where the conductor structure layer 24 includes N (N is an integer number equal to three or more) micro particle layers 29-1 to 29-N, it is desirable that the island 28-N of the Nth micro particle layer 29-N is smaller than the island 28-(N-1) of the (N-1)th micro particle layer 29-(N-1), and, at least, it is necessary that they are nearly in the same size.

That is, as has been explained with reference to Fig. 2, because of the structure in which the islands 28 as micro conductor particles are developed in the two-dimensional plane, the radiation to the XY-plane may be reduced. Similarly, as shown in Fig. 5, because of the multilayer structure of the islands 28, of the radiations in the Z-direction, the radiation in the direction opposite to the traveling direction of the incident electromagnetic wave may be reduced.

As a result, in the conductor structure layer 24, the reflection ratio of the light entering from the upper side may be reduced, and light transmission efficiency may be improved.

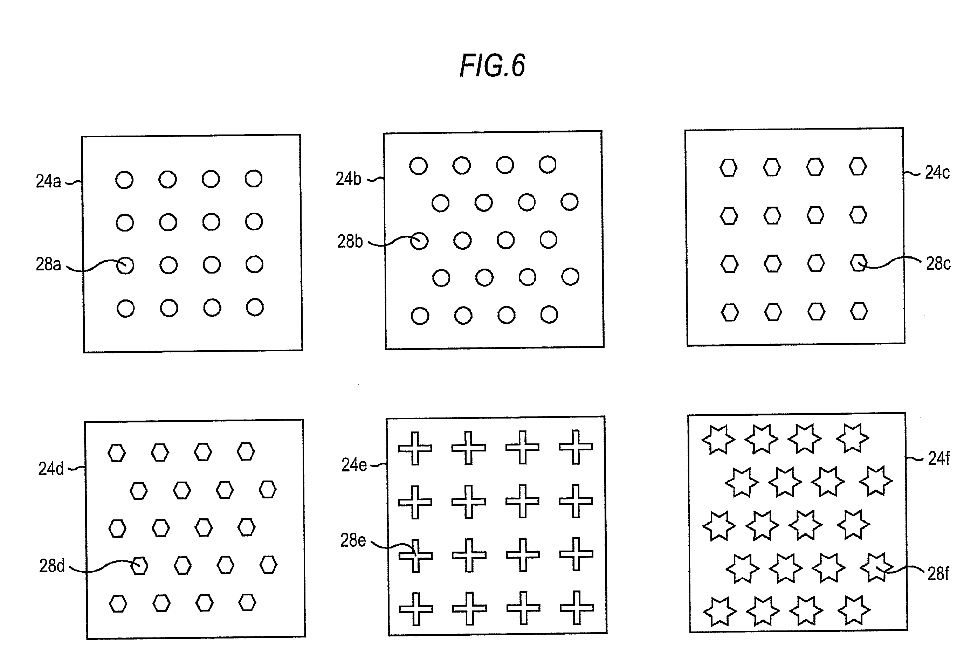

Next, configuration examples of the conductor structure layer 24 will be explained with reference to Figs. 6 to 8.

Fig. 6 shows XY-plane structures in single layers of six kinds of conductor structure layers 24a to 24f.

The conductor structure layer 24a is a configuration example in which circular (cylindrical) islands 28a are arranged to be orthogonal to the XY-axis at equal intervals in an orthogonal matrix. The conductor structure layer 24b is a configuration example in which circular (cylindrical) islands 28b are arranged at equal intervals in honeycomb geometry, and the arrangement is beneficial because the intervals of the adjacent islands 28 are isotropic. Further, it is beneficial to use circular micro conductor particles like the islands 28a and 28b, however, shapes other than the circular shapes, for example, spherical shapes or ellipsoidal shapes may be used.

Furthermore, for example, the conductor structure layer 24c is a configuration example in which hexagonal (hexagonal columnar) islands 28c are arranged at equal intervals in an orthogonal matrix, and the conductor structure layer 24d is a configuration example in which hexagonal islands 28c are arranged at equal intervals in honeycomb geometry. Similarly, islands in polygonal columnar shapes such as triangular (triangular prism) or rectangular (quadrangular prism) may be employed.

Further, the conductor structure layer 24e is a configuration example in which cruciform islands 28e are arranged at equal intervals in an orthogonal matrix, and the conductor structure layer 24f is a configuration example in which star-shaped islands 28f are arranged at equal intervals in honeycomb geometry. As described above, islands in shapes having concavo-convex structures in specific directions may be employed.

Here, the typical size of the island 28 is about 20 nm to 100 nm, and the intervals between the respective adjacent islands 28 are about a half of the wavelength of light in a medium. That is, in the case where the conductor structure layer 24 is used in a visible light wavelength range, it is preferable that, when the light transmitted through the conductor structure layer 24 is blue (λ = 400 nm), the basic intervals between the respective adjacent islands 28 are 400 nm/η.

Similarly, it is beneficial that, when the light transmitted through the conductor structure layer 24 is green (λ = 550 nm), the basic intervals between the adjacent islands 28 are 550 nm/η. Further, it is preferable that, when the light transmitted through the conductor structure layer 24 is red (λ = 650 nm), the basic intervals between the adjacent islands 28 are 650 nm/η. Here, η is an effective refractive index in the medium in which the conductor structure layer 24 is embedded. Note that these intervals strictly have degrees of freedom of design from a half to twice the above described value because the optical property changes depending on the material, thickness, size, or the like of the islands 28.

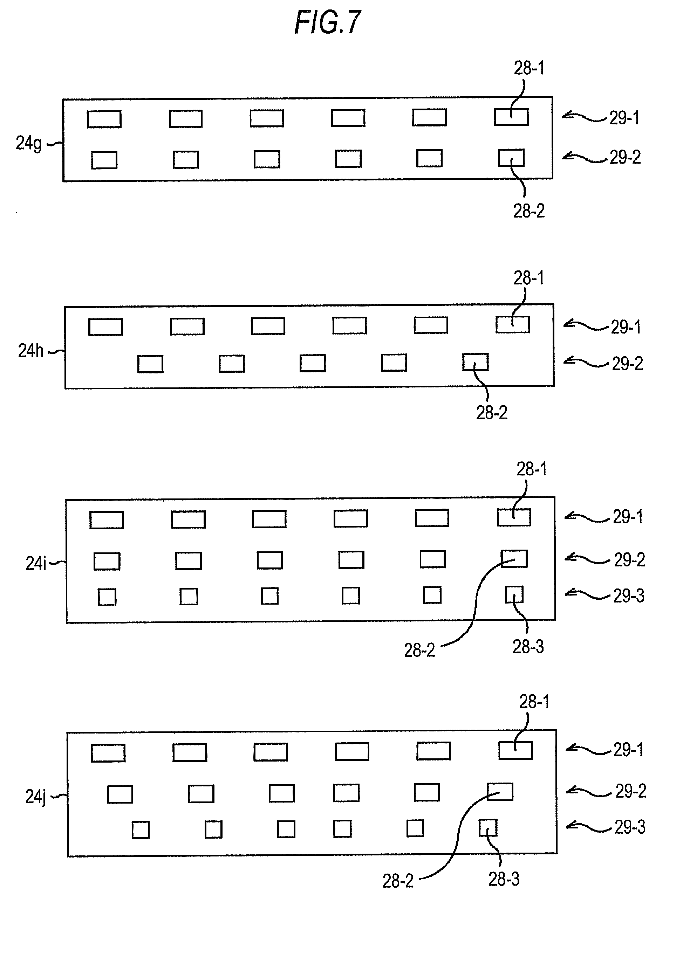

Next, Fig. 7 shows sectional structures (laminated structures) of four kinds of conductor structure layers 24g to 24j.

The conductor structure layer 24g is a configuration example in which the respective islands 28-1 of the micro particle layer 29-1 are arranged immediately above the respective islands 28-2 of the micro particle layer 29-2, and the configuration is preferable. Further, the conductor structure layer 24h is a configuration example in which the respective islands 28-1 of the micro particle layer 29-1 are (alternatively) arranged offset relative to the respective islands 28-2 of the micro particle layer 29-2, and the configuration may be employed. Furthermore, as described above, it is desirable that the size of the island 28-2 of the micro particle layer 29-2 is equal to or slightly smaller than that of the island 28-1 of the micro particle layer 29-1.

The conductor structure layer 24i is a configuration example in which three micro particle layers 29-1 to 29-3 are formed, and the respective islands 28-1 are arranged immediately above the respective islands 28-2 and the respective islands 28-2 are arranged immediately above the respective islands 28-3. As described above, also, in the case of the three-layer structure, it is desirable that the size of the island 28-2 is equal to or slightly smaller than that of the island 28-1 and the size of the island 28-3 is equal to or slightly smaller than that of the island 28-2.

Further, the conductor structure layer 24j is a configuration example in which three micro particle layers 29-1 to 29-3 are formed, and the islands 28-2 of the micro particle layer 29-2 corresponding to the islands 28-1 of the micro particle layer 29-1 are shifted toward inside. Furthermore, the islands 28-3 of the micro particle layer 29-3 corresponding to the islands 28-2 of the micro particle layer 29-2 are shifted toward inside. As described above, by shifting the islands 28 at the lower layer side toward the inner side, the incident light from the upper side may be bent inward and a function as a focusing device may be provided.

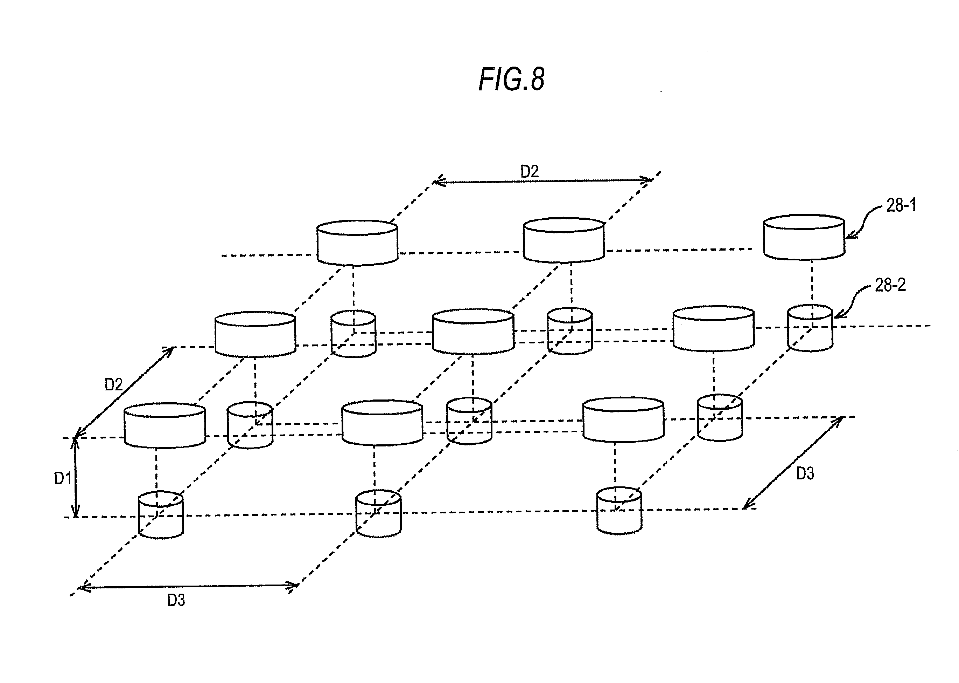

Next, Fig. 8 stereoscopically shows positional relationships of respective islands 28 forming the conductor structure layer 24.

The size of the island 28 is set to about 10 nm to 100 nm in dimensions and thickness. The layer distance D1 between the micro particle layer 29-1 including the islands 28-1 and the micro particle layer 29-2 including the islands 28-2 is a quarter wavelength (λ/4) of the detection wavelength. The distance D2 between the adjacent islands 28-1 is about a half wavelength of the detection wavelength and a desired electromagnetic wavelength may be selected by optimizing the distance D2. Further, it is beneficial that the distance D3 between the adjacent islands 28-2 is equal to the distance D2 between the adjacent islands 28-1 or smaller than the distance D2. Furthermore, it is beneficial that the size of the island 28-2 is equal to or smaller than that of the island 28-1.

Note that the conductor structure layer having the two-layer structure is shown in Fig. 8, however, in a conductor structure layer having three or more layers, the relationship between the first micro particle layer 29-1 and the second micro particle layer 29-2 and the relationship between the (N-1)th micro particle layer 29-(N-1) and the Nth micro particle layer 29-N are equal.

In the above description, the conductor structure layer 24 employing the island array structure in which islands 28 as micro conductor particles are two-dimensionally arranged at predetermined periodic intervals has been explained, however, as the conductor structure layer, a hole array structure in which holes (apertures) are two-dimensionally arranged at predetermined periodic intervals on a conductor thin film may be employed.

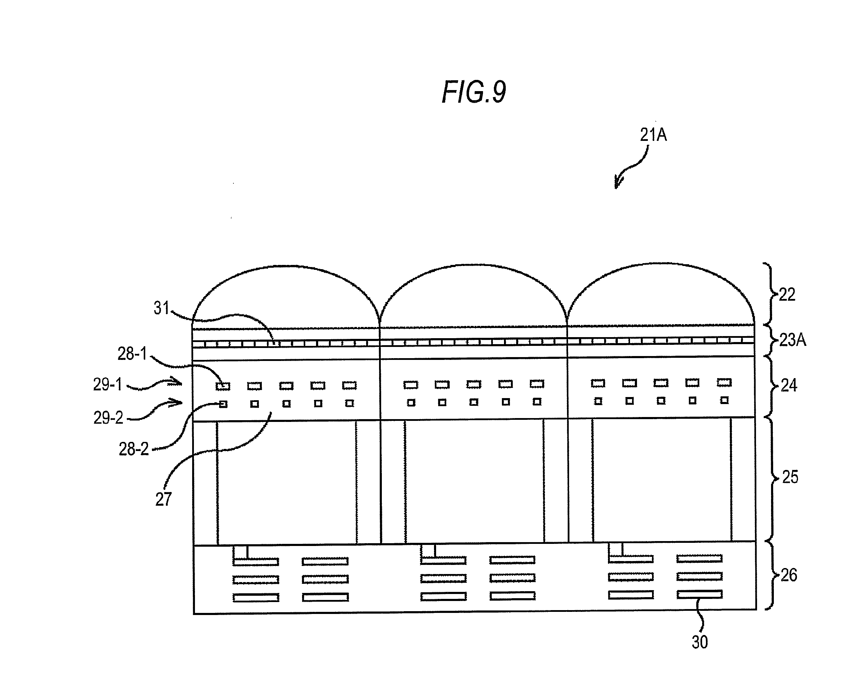

Next, Fig. 9 is a schematic sectional view showing the second embodiment of a solid-state image sensing device according to an embodiment of the present invention. In Fig. 9, like the solid-state image sensing device 21 in Fig. 4, a solid-state image sensing device 21A formed by mounting a conductor structure layer on a back side illumination CMOS solid-state image sensing device is shown.

The solid-state image sensing device 21A includes an on-chip micro lens 22, a color filter layer 23A, a conductor structure layer 24, a photodiode layer 25, and a signal wiring layer 26 stacked sequentially from the upside like the solid-state image sensing device 21 in Fig. 4. Here, the on-chip micro lens 22, the conductor structure layer 24, the photodiode layer 25, and the signal wiring layer 26 forming the solid-state image sensing device 21A are the same as corresponding respective layers of the solid-state image sensing device 21 in Fig. 4, and their detailed explanation will be omitted.

That is, in the solid-state image sensing device 21A, the color filter layer 23A has a different configuration from that of the color filter layer 23 of the solid-state image sensing device 21. The color filter layer 23A has a conductor thin film 31 of aluminum or the like, and the conductor thin film 31 has a hole array structure in which holes are two-dimensionally arranged at predetermined periodic intervals and functions as a metal filter. In the hole array structure of the conductor thin film 31, hole intervals are preferably nearly equal to the detection wavelength.

As described above, by employing the conductor thin film 31 in the color filter layer 23A, deterioration may be suppressed compared to the case where organic molecules or pigments are employed. In the solid-state image sensing device 21A in Fig. 9, the color filter layer 23A is provided on the conductor structure layer 24, however, the conductor structure layer 24 may be provided on the color filter layer 23A.

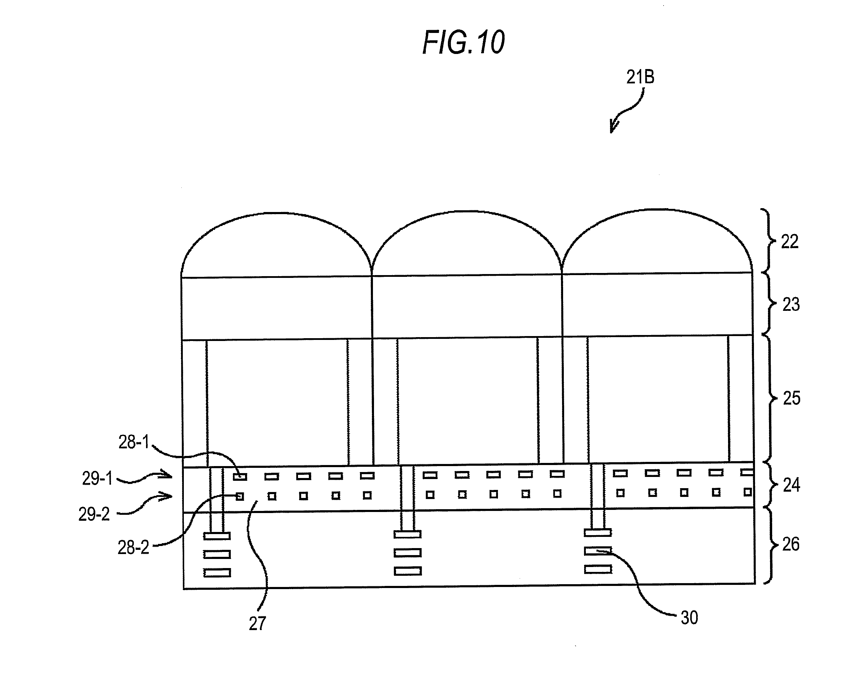

Next, Fig. 10 is a schematic sectional view showing the third embodiment of a solid-state image sensing device according to an embodiment of the present invention. In Fig. 10, like the solid-state image sensing device 21 in Fig. 4, a solid-state image sensing device 21 B formed by mounting a conductor structure layer on a back side illumination CMOS solid-state image sensing device is shown.

The solid-state image sensing device 21 B includes an on-chip micro lens 22, a color filter layer 23, a photodiode layer 25, a conductor structure layer 24, and a signal wiring layer 26 stacked sequentially from the upside. Here, the respective layers forming the solid-state image sensing device 21 B are the same as corresponding respective layers of the solid-state image sensing device 21 in Fig. 4, and their detailed explanation will be omitted.

That is, in the solid-state image sensing device 21 B, unlike the solid-state image sensing device 21, the conductor structure layer 24 is provided under the photodiode layer 25.

As described above, by providing the conductor structure layer 24 under the photodiode layer 25, reflection on the lower surface of the photodiode layer 25 may be prevented and occurrence of color mixing may be suppressed.

That is, since silicon absorption has sensitivity from visible wavelength to near infrared wavelength range (380 nm to 1100 nm), the absorption coefficient becomes smaller for electromagnetic wave having the longer wavelength, and the red and near infrared wavelength components are transmitted through the photodiode layer 25. In this regard, in the configuration in which the signal wiring layer 26 is provided below the photodiode layer 25, the components reflected on the interface may be mixed in the adjacent pixels and cause color mixing. On the other hand, by providing the conductor structure layer 24 under the photodiode layer 25, though the components are reflected on the single-layer metal thin film, the reflected components may be allowed to interfere with each other and cancelled out, and the above described occurrence of color mixing due to reflection on the interface may be suppressed.

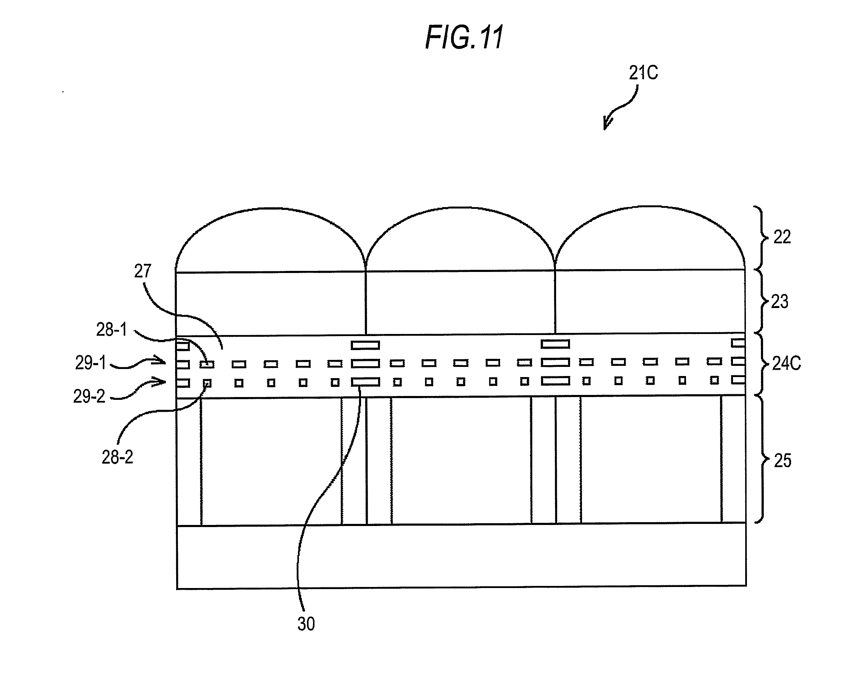

Next, Fig. 11 is a schematic sectional view showing the fourth embodiment of a solid-state image sensing device according to an embodiment of the present invention. In Fig. 11, like the solid-state image sensing device 21 in Fig. 4, a solid-state image sensing device 21C formed by mounting a conductor structure layer on a back side illumination CMOS solid-state image sensing device is shown.

The solid-state image sensing device 21C includes an on-chip micro lens 22, a color filter layer 23, a conductor structure layer 24C, and a photodiode layer 25 stacked sequentially from the upside. Here, the on-chip micro lens 22, the color filter layer 23, and the photodiode layer 25 of the solid-state image sensing device 21C are the same as corresponding respective layers of the solid-state image sensing device 21 in Fig. 4, and their detailed explanation will be omitted.

That is, in the solid-state image sensing device 21C, unlike the conductor structure layer 24 of the solid-state image sensing device 21, wiring lines 30 are formed in the conductor structure layer 24C. As described above, since the wiring lines 30 are formed with the micro particle layer 29-1 and the micro particle layer 29-2 in the conductor structure layer 24C, increase in the manufacturing process due to addition of the conductor structure layer 24C may be suppressed to the minimum.

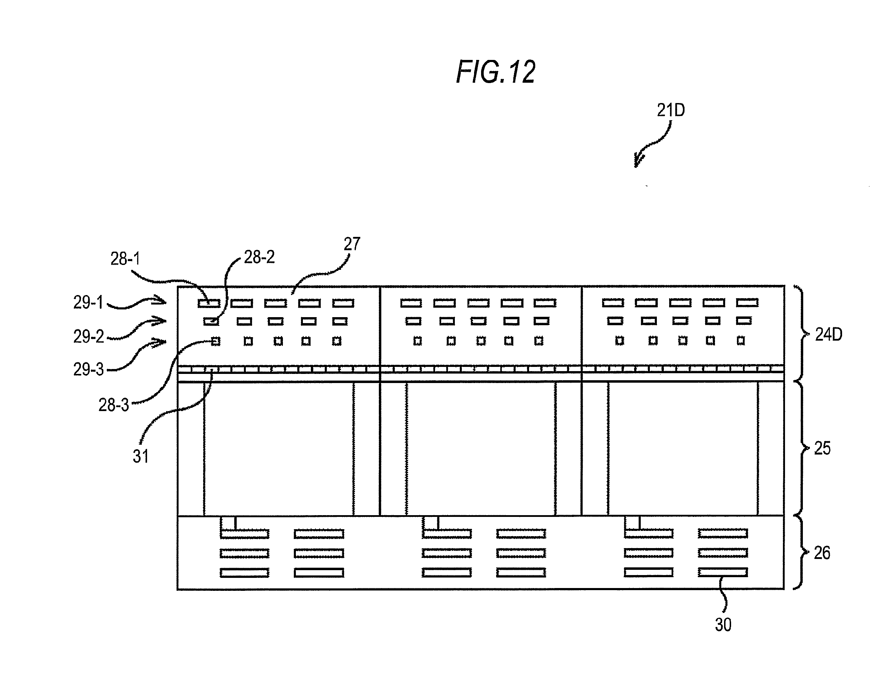

Next, Fig. 12 is a schematic sectional view showing the fifth embodiment of a solid-state image sensing device according to an embodiment of the present invention. In Fig. 12, like the solid-state image sensing device 21 in Fig. 4, a solid-state image sensing device 21D formed by mounting a conductor structure layer on a back side illumination CMOS solid-state image sensing device is shown.

The solid-state image sensing device 21D includes a conductor structure layer 24D, a photodiode layer 25, and a signal wiring layer 26 stacked. Here, the photodiode layer 25 and the signal wiring layer 26 of the solid-state image sensing device 21D are the same as corresponding respective layers of the solid-state image sensing device 21 in Fig. 4, and their detailed explanation will be omitted.

That is, in the solid-state image sensing device 21D, the conductor structure layer 24D has a different configuration from that of the conductor structure layer 24 of the solid-state image sensing device 21. In the conductor structure layer 24D of the solid-state image sensing device 21D, three micro particle layers 29-1 to 29-3 are formed. Further, the arrangement of the islands 28-2 of the micro particle layer 29-2 is deflected toward the center compared to the arrangement of the islands 28-1 of the micro particle layer 29-1, and the arrangement of the islands 28-3 of the micro particle layer 29-3 is deflected to the center compared to the arrangement of the islands 28-2 of the micro particle layer 29-2. By the arrangements, the lights entering from the upper side are focused on the center part of the photodiode by the micro particle layers 29-1 to 29-3.

That is, in the solid-state image sensing device 21D, since the arrangements of the islands 28-1 to 28-3 are shifted to be deflected to the center of the photodiode toward the lower layers in the micro particle layers 29-1 to 29-3, and a function as an on-chip focusing device is provided.

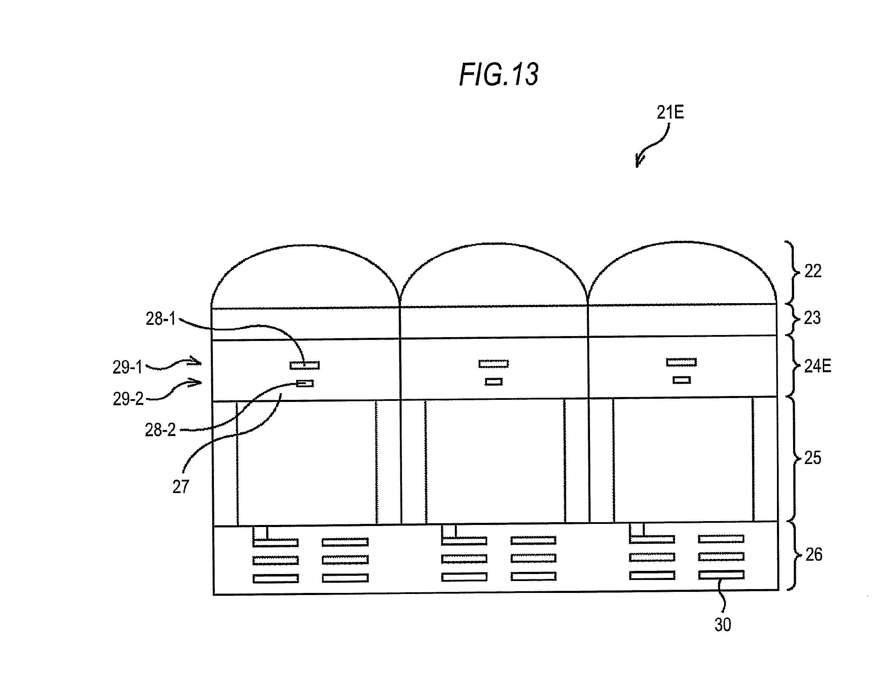

Next, Fig. 13 is a schematic sectional view showing the sixth embodiment of a solid-state image sensing device according to an embodiment of the present invention. In Fig. 13, like the solid-state image sensing device 21 in Fig. 4, a solid-state image sensing device 21 E formed by mounting a conductor structure layer on a back side illumination CMOS solid-state image sensing device is shown.

The solid-state image sensing device 21 E includes an on-chip micro lens 22, a color filter layer 23, a conductor structure layer 24E, a photodiode layer 25, and a signal wiring layer 26 stacked. Here, the on-chip micro lens 22, the color filter layer 23, the photodiode layer 25, and the signal wiring layer 26 of the solid-state image sensing device 21 E are the same as corresponding respective layers of the solid-state image sensing device 21 in Fig. 4, and their detailed explanation will be omitted.

That is, in the solid-state image sensing device 21 E, the conductor structure layer 24E has a different configuration from that of the conductor structure layer 24 of the solid-state image sensing device 21. In the conductor structure layer 24E of the solid-state image sensing device 21 E, two micro particle layers 29-1 and 29-2 are formed. Further, one island 28-1 is provided for each pixel in the micro particle layer 29-1, and one island 28-2 is provided for each pixel in the micro particle layer 29-2. Furthermore, it is desirable that the island 28-2 of the micro particle layer 29-2 is slightly smaller than the island 28-1 of the micro particle layer 29-1.

Here, in the micro particle layer 29, the islands 28 are two-dimensional periodically arranged on the XY-plane at the basic intervals as described above with reference to Fig. 6, however, the periodic number of the islands 28 provided within a pixel or a pixel block including plural pixels increases and decreases depending on the pixel size. For example, in the case where one side of the pixel size is smaller than X times (here, X is a positive integer number) the basic interval of the islands 28, the number of islands smaller than X is preferable. Further, in the case where the other side of the pixel size is smaller than Y times (here, Y is a positive integer number and may be the same as X or not) the basic interval of the islands 28, the number of islands smaller than Y is preferable. Therefore, in the case where the pixel size is minute, the number of islands may be one for both X and Y, that is, only one island 28 may be provided on the XY-plane for one pixel.

That is, when the pixel size of the solid-state image sensing device 21 E is nearly equal to the basic interval between the islands 28, it is difficult to develop plural islands 28 on the XY-plane with respect to each pixel. Accordingly, in the solid-state image sensing device 21 E, one island 28 is provided with respect to each pixel and the micro particle layer 29 is formed. Note that, in Fig. 13, the configuration example in which the two micro particle layers 29-1 and 29-2 are provided has been shown, however, three or more micro particle layers may be provided.

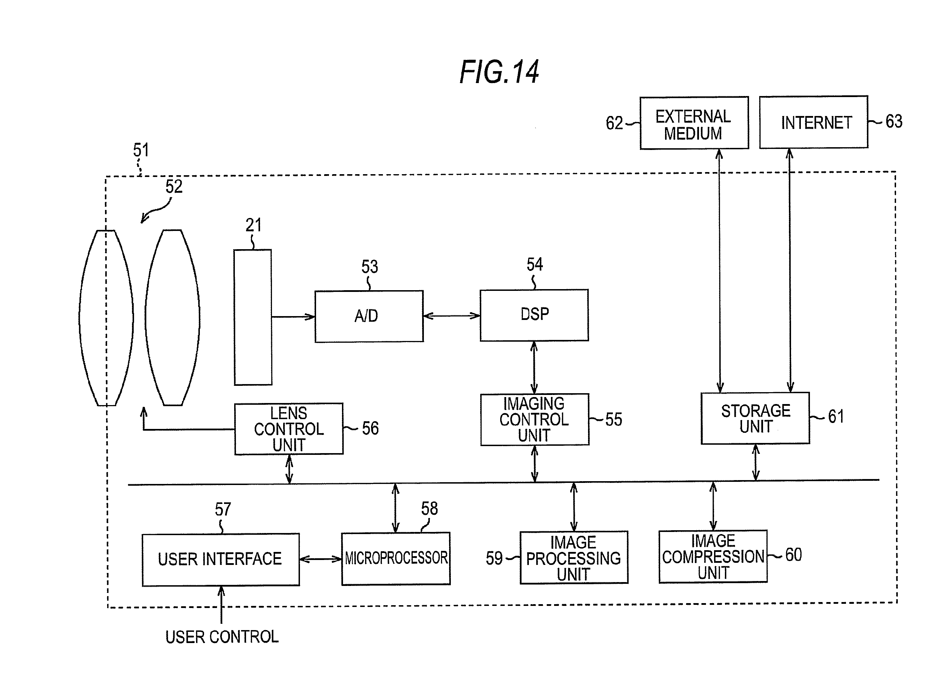

Next, Fig. 14 is a block diagram showing a configuration example of an imaging apparatus (digital still camera) with the solid-state image sensing device 21 having the conductor structure layer 24 mounted thereon.

In Fig. 14, an imaging apparatus 51 includes the solid-state image sensing device 21, a lens unit 52, an A/D (analog/digital) conversion unit 53, a DSP (digital signal processor) 54, an imaging control unit 55, a lens control unit 56, a user interface 57, a microprocessor 58, an image processing unit 59, an image compression unit 60, and a storage unit 61.

The solid-state image sensing device 21 has the above described conductor structure layer 24, and light (optical information) focused via the lens unit 52 is converted into charge signals by photoelectric conversion devices of the respective pixels and output to the A/D conversion unit 53.

The lens unit 52 has a lens group of plural lenses including a zoom lens, an imaging lens, etc., and focuses light (image information) from an object (not shown) on a light receiving surface of the solid-state image sensing device 21. The A/D conversion unit 53 converts the charge signals output from the respective pixels of the solid-state image sensing device 21 into digital signal values corresponding to received light intensity of the pixels, and outputs them as pixel data. The DSP 54 creates images by performing image correction by demosaicing and signal processing of γ-correction, white balance, or the like on the pixel data output from the A/D conversion unit 53, and supplies the image data to the imaging control unit 55.

The imaging control unit 55 performs control of the respective blocks of the imaging apparatus 51. For example, if a control signal representing that a user operates a shutter button (not shown) is supplied to the imaging control unit 55 via the user interface 57 and the microprocessor 58, then, the imaging control unit 55 supplies the image data output from the DSP 54 to the image processing unit 59 and performs image processing thereon, supplies the data to the image compression unit 60 and compresses it, and then, supplies the data to the storage unit 61 for storage according to the user control.

If a control signal representing that a user operates a zoom lever (not shown) is supplied via the user interface 57 and the microprocessor 58, then, the lens control unit 56 drives the lens unit 52 to adjust a zoom factor according to the user control.

If a user operates an operation part (not shown), the user interface 57 acquires a control signal in response to the user's operation and supplies it to the microprocessor 58. The microprocessor 58 supplies the control signal from the user interface 57 to the block suitable for the control.

The image processing unit 59 performs image processing of noise removal or the like on the image data output from the DSP 54. The image compression unit 60 performs compression processing by JPEG format or MPEG format on the image data image-processed by the image processing unit 59.

The storage unit 61 has a storage part of a flash memory (for example, EEPROM (Electronically Erasable and Programmable Read Only Memory) or the like, and stores the image data compression-processed by the image compression unit 60. Further, the image data stored in the storage unit 61 may be transferred to an external medium 62 via a drive (not shown) or uploaded to the Internet 63 via a communication part (not shown).

As described above, by applying the properties of surface localized plasmon accompanying the islands 28 as micro conductor particles forming the conductor structure layer 24 to the solid-state image sensing device 21, higher performance of the solid-state image sensing device 21 may be realized.

For example, by the conductor structure layer 24, the light absorption efficiency in silicon per unit thickness may be improved. Specifically, red wavelength or near infrared components are photoelectrically converted efficiently in the shallow part of the silicon forming the photodiode layer 25. Thereby, the photoelectric conversion efficiency of long-wavelength components may be improved by the thinner film silicon substrate or the substrate thickness equal to that in known devices.

Further, since the red wavelength or near infrared components are photoelectrically converted in the shallow part of the silicon, the incident light obliquely entering the light receiving surface of the solid-state image sensing device 21 may be suppressed from entering neighborhood pixels, and the adverse effect on the images due to occurrence of color mixing into the neighborhood pixels may be reduced.

Furthermore, in the case where the conductor structure layer 24 is used as a color filter, the color filter layer itself may be made shorter in height compared to the color filter using organic compounds or pigments in known devices. In addition, since the conductor structure layer 24 is formed by a metal, durability to withstand external stimuli such as ultraviolet rays or the like may be improved. Moreover, in the conductor structure layer 24, the transmitted wavelengths may be set by the physical structure and a color filter optimized for an arbitrary wavelength may be realized.

Further, in the conductor structure layer 24, since the micro particle layers 29 are stacked, advantages of improvement of transmittance and reduction of reflection may be obtained by the characteristics that directionality is produced in the near-field light and dipole radiation accompanying the conductors compared to the case where the conductor structure layer 24 has a single-layer structure. Furthermore, using the characteristics, by providing the conductor structure layer 24 on the photodiode layer 25, the incident light intensity may be improved. Moreover, using the characteristics, by providing the conductor structure layer 24 under the photodiode layer 25, reflection and reverse of the components transmitted through the photodiode layer 25 may be prevented.

In addition, as shown in the conductor structure layer 24D in Fig. 12, the function as the on-chip focusing device that focuses the light entering from the upside on the center may be realized.

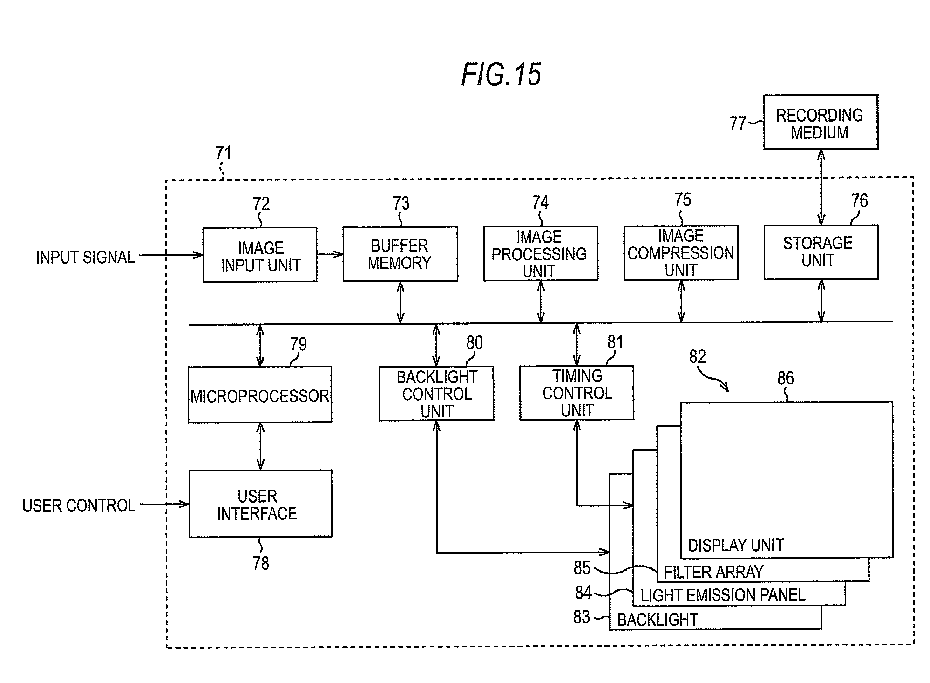

Next, Fig. 15 is a block diagram showing a configuration example of a signal indication apparatus with a display panel having the conductor structure layer 24 mounted thereon.

In a signal indication apparatus 71, input signals representing image data are input from an image input unit 72, temporarily stored in a buffer memory 73, and then, appropriately loaded in an image processing unit 74 and image-processed. The image data image-processed by the image processing unit 74 is compression-processed by an image compression unit 75, and stored in a storage unit 76 or transferred to a recording medium 77 via a drive (not shown). Further, a control signal input when a user operates an operation unit (not shown) is supplied to the respective units within the signal indication apparatus 71 via a user interface 78 and a microprocessor 79.

Furthermore, the image data image-processed by the image processing unit 74 is drawn on a display panel 82 by control of a backlight control unit 80 and a timing control unit 81. The display panel 82 includes a backlight 83, a light emission panel 84, a filter array 85, and a display unit 86. In the display panel 82, the backlight 83 and the light emission panel 84 emit light in response to the backlight control unit 80 and the timing control unit 81, and thereby, images are displayed on the display unit 86 via the filter array 85 for display of desired colors.

Here, in the signal indication apparatus 71, the conductor structure layer 24 may be used as antireflection films of the filter array 85 and the backlight 83 forming the display panel 82.

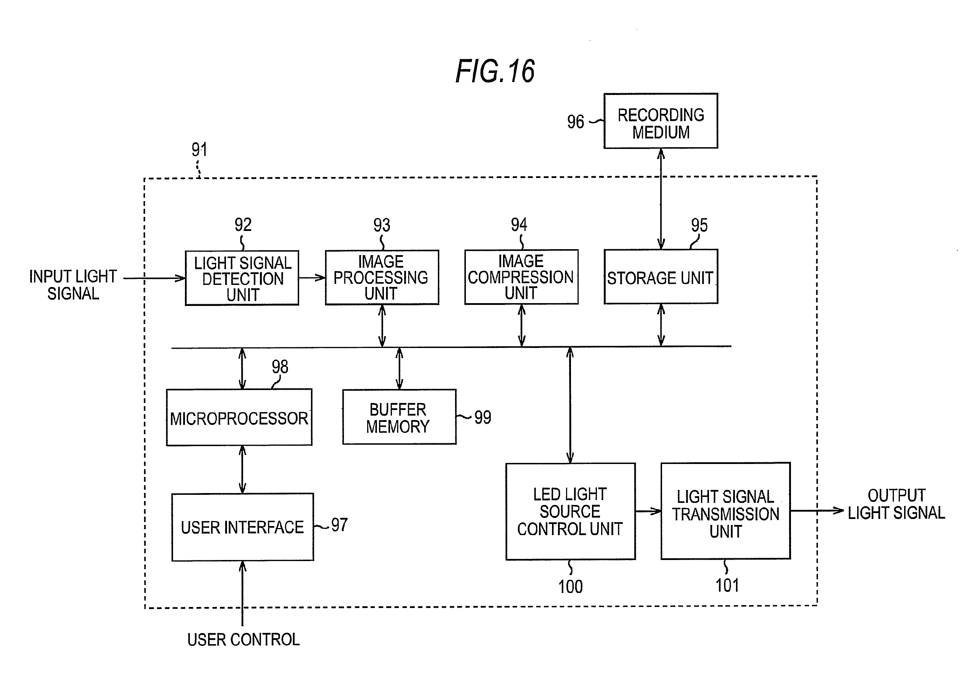

Next, Fig. 16 is a block diagram showing a configuration example of an information communication apparatus with a light signal detection unit having the conductor structure layer 24 mounted thereon.

In an information communication apparatus 91, for example, input light signals representing image data are detected by photoelectric conversion devices of a light signal detection unit 92, and converted into electric signals and supplied to an image processing unit 93. The image data is image-processed by the image processing unit 93, then, compression-processed by an image compression unit 94, and stored in a storage unit 95 or transferred to a recording medium 96 via a drive (not shown). Further, a control signal input when a user operates an operation unit (not shown) is supplied to the respective units within the information communication apparatus 91 via a user interface 97 and a microprocessor 98.

Furthermore, the image data image-processed by the image processing unit 93 is temporarily stored in a buffer memory 99, and then, appropriately loaded in an LED (Light Emitting Diode) light source control unit 100. The LED light source control unit 100 controls a light signal transmission unit 101 to transmit the data as output light signals to the outside.

Here, in the information communication apparatus 91, the conductor structure layer 24 may be employed on the light receiving surfaces of the photoelectric conversion devices of the light signal detection unit 92, and the light reception efficiency of light signals may be improved by the antireflection function of the conductor structure layer 24.

Next, a manufacturing method of the micro particle layer 29 forming the conductor structure layer 24 will be explained.

First, an insulating layer is fabricated on a light receiving surface as a substrate, and a metal layer of aluminum is deposited on entire surface by sputtering (PVD: Physical Vapor Deposition). Then, a photomask is deposited on the metal layer deposited on the entire surface. A positive resist may be employed for the photomask, and the resist is applied and baked.

Then, by reduced projection exposure, a conductor pattern in response to the islands 28 forming the micro particle layer 29 is transferred to the resist. For transfer of the conductor pattern, lithography using an ArF (argon fluoride) laser, an F2 excimer laser, extreme ultra violet lithography (EUVL), electron projection lithography, X-ray lithography, or the like suitable for working with high resolution may be preferable. In addition, electron beam lithography of directly drawing with electron beams may be used.

Then, unnecessary metal regions are removed by reactive ion etching, and thereby, the micro particle layer 29 having the desired conductor pattern is realized.

Further, in the case where two, three, or more micro particle layers 29 are stacked, the above described steps are repeatedly performed, and thereby, the conductor structure layer 24 having the laminated structure may be manufactured.

As another working method, a method of performing microfabrication using thermal cycle nanoimprinting, photonanoimprinting, or the like, filling groove parts formed by the microfabrication with metal layers, and polishing the surface may be employed.

Further, as long as the micro particle layer 29 may be realized with high accuracy, the method is not limited to the above described method. Furthermore, in the above described method, the method of mounting the conductor structure layer 24 using aluminum, which is used as a signal wiring layer and a light blocking layer in a typical manufacturing process of a CMOS solid-state image sensing device, has been explained, however, a conductor other than aluminum, for example, silver or the like may be used.

In addition, the conductor structure layer 24 basically has a structure in which multiple micro particle layers 29 are stacked via insulating layers of silicon oxide films or silicon nitride films on a photodetection device surface of the solid-state image sensing device 21. The photodetection device is not limited to the CMOS solid-state image sensing device, and it is obvious that a CCD solid-state image sensing device or an arbitrary device having a photoelectric conversion function may be employed. Furthermore, the structure and the manufacturing method of the photoelectric conversion device are known technology, and the detailed explanation will be omitted.

Further, the solid-state image sensing device 21 may be applied to a camcorder or an information terminal apparatus having an imaging device in addition to the imaging apparatus 51.

As described herein, the plasmon resonator includes not only a structure in which islands 28 as conductor metal particles are formed by microfabrication at the predetermined periodic intervals that has been explained with reference to Fig. 4 but also a structure of a conductor metal in which holes (through holes or non-through holes) are formed by microfabrication, and they are referred to as conductor metal structures having concavo-convex structures at predetermined periodic intervals. That is, it is only necessary that the plasmon resonator has a pattern structure in which holes or islands are repeatedly arranged at predetermined periodic intervals. Note that the plasmon resonator may be formed not only by two-dimensionally arranging holes or islands, but also, for example, by one-dimensionally arranging (linearly arranging) holes or islands.

The present invention is not limited to the above described embodiments, and various changes may be made without departing from the scope of the present invention as defined by the appended claims.

## Claims

1. An imaging device (21) comprising:
a photoelectric conversion layer (25) in which photoelectric conversion devices that convert received light into charge are arranged in a planar fashion; and
a conductor structure layer (24) provided on an upper surface or a lower surface of the photoelectric conversion layer and formed by stacking plural conductor layers (29-1, 29-2), each conductor layer having islands made of a conductor metal at predetermined periodic intervals within a plane parallel to light receiving surfaces of the photoelectric conversion devices;
wherein the size of the islands is smaller than an effective electromagnetic wavelength (λ) detected by the corresponding photoelectric conversion devices in a medium containing the conductor layers;
wherein the size of the islands in the nth conductor layer is smaller than the size of the islands in the (*n-1*)th layer, where n increases in the travelling direction of the incident received light,
**characterized in that**
the distance between one conductor layer and the next conductor layer in the travelling direction of the incident received light is a quarter of said effective electromagnetic wavelength (λ/4).

2. The imaging device according to any preceding claim, wherein the conductor structure layer is formed by providing the conductor layers within an insulating layer (27) made of an insulating material.

3. The imaging device according to any preceding claim, wherein each conductive layer is formed of islands of a conductor metal having a plasma frequency in an ultraviolet wavelength range in a two-dimensional arrangement at periodic intervals equal to or less than said effective electromagnetic wavelength.

4. The imaging device according to any preceding claim, wherein the electromagnetic wavelength detected in the photoelectric conversion layer has a longer wavelength than red wavelengths, and wherein each conductive layer is formed of islands of a conductor metal having a plasma frequency in a visible wavelength range in a two-dimensional arrangement at periodic intervals equal to or less than the detected electromagnetic wavelength.

5. The imaging device according to any preceding claim, wherein the predetermined periodic intervals of the conductor layers forming the conductor structure layer are set in response to electromagnetic wavelengths detected by respective ones of the photoelectric conversion devices arranged in the planar fashion in the photoelectric conversion layer.

6. An imaging apparatus including the imaging device of any preceding claim.

## Patentansprüche

1. Bildgebungsvorrichtung (21), die Folgendes umfasst:
eine Schicht (25) zur photoelektrischen Umsetzung, in der Vorrichtungen zur photoelektrischen Umsetzung, die empfangenes Licht in elektrische Ladung umsetzen, eben angeordnet sind; und
eine Leiterstrukturschicht (24), die auf einer oberen Oberfläche oder auf einer unteren Oberfläche der Schicht zur photoelektrischen Umsetzung vorgesehen ist und durch Stapeln mehrerer Leiterschichten (29-1, 29-2) gebildet ist, wobei jede Leiterschicht Inseln, die aus einem Leitermetall hergestellt sind, in vorgegebenen periodischen Intervallen in einer Ebene parallel zu Lichtaufnahmeoberflächen der Vorrichtungen zur photoelektrischen Umsetzung besitzt;
wobei die Größe der Inseln kleiner als eine durch die entsprechenden Vorrichtungen zur photoelektrischen Umsetzung detektierte effektive elektromagnetische Wellenlänge (λ) in einem die Leiterschichten enthaltenden Medium ist;
wobei die Größe der Inseln in der n-ten Leiterschicht kleiner als die Größe der Inseln in der (n - 1)-ten Schicht ist, wobei n in der Ausbreitungsrichtung des auftreffenden empfangenen Lichts zunimmt,
**dadurch gekennzeichnet, dass**
der Abstand zwischen einer Leiterschicht und der nächsten Leiterschicht in der Ausbreitungsrichtung des auftreffenden empfangenen Lichts ein Viertel der effektiven elektromagnetischen Wellenlänge (λ/4) beträgt.

2. Bildgebungsvorrichtung nach einem vorhergehenden Anspruch, wobei die Leiterstrukturschicht durch Vorsehen von Leiterschichten in einer aus einem Isoliermaterial hergestellten Isolierschicht (27) gebildet ist.

3. Bildgebungsvorrichtung nach einem vorhergehenden Anspruch, wobei jede Leiterschicht aus Inseln eines Leitermetalls, das eine Plasmafrequenz in einem Bereich ultravioletter Wellenlänge besitzt, in einer zweidimensionalen Anordnung in periodischen Intervallen, die gleich oder kleiner als die effektive elektromagnetische Wellenlänge sind, gebildet ist.

4. Bildgebungsvorrichtung nach einem vorhergehenden Anspruch, wobei die in der Schicht zur photoelektrischen Umsetzung detektierte elektromagnetische Wellenlänge eine größere Wellenlänge als rote Wellenlängen besitzt und wobei jede leitende Schicht aus Inseln eines Leitermetalls, das ein Plasmafrequenz im Bereich sichtbarer Wellenlängen besitzt, in einer zweidimensionalen Anordnung in periodischen Intervallen, die gleich oder kleiner als die detektierte elektromagnetische Wellenlänge sind, gebildet ist.

5. Bildgebungsvorrichtung nach einem vorhergehenden Anspruch, wobei die vorgegebenen periodische Intervalle der Leiterschichten, die die Leiterstrukturschicht bilden, in Reaktion auf elektromagnetische Wellenlängen, die durch Entsprechende der Vorrichtungen zur photoelektrischen Umsetzung detektiert werden, die in der Schicht zur photoelektrischen Umsetzung eben angeordnet sind, eingestellt werden.

6. Bildgebungsgerät, das die Bildgebungsvorrichtung nach einem vorhergehenden Anspruch enthält.

## Revendications

1. Dispositif d'imagerie (21) comprenant :
une couche de conversion photoélectrique (25) dans laquelle des dispositifs de conversion photoélectrique qui convertissent la lumière reçue en charge sont agencés d'une manière planaire ; et
une couche de structure conductrice (24) disposée sur une surface supérieure ou une surface inférieure de la couche de conversion photoélectrique et formée en empilant plusieurs couches conductrices (29-1, 29-2), chaque couche conductrice ayant des îlots constitués d'un métal conducteur à des intervalles périodiques prédéterminés dans un plan parallèle aux surfaces recevant la lumière des dispositifs de conversion photoélectrique ;
dans lequel la taille des îlots est inférieure à une longueur d'onde électromagnétique effective (λ) détectée par les dispositifs de conversion photoélectrique correspondants dans un milieu contenant les couches conductrices ;
dans lequel la taille des îlots dans la *n*^{ième} couche conductrice est inférieure à la taille des îlots dans la (*n-1*)^{ème} couche, où n augmente dans la direction de propagation de la lumière incidente reçue,
**caractérisé en ce que**
la distance entre une couche conductrice et la couche conductrice suivante dans la direction de propagation de la lumière incidente reçue représente un quart de ladite longueur d'onde électromagnétique effective (λ/4).

2. Dispositif d'imagerie selon la revendication 1, dans lequel la couche de structure conductrice est formée en disposant les couches conductrices à l'intérieur d'une couche isolante (27) constituée d'un matériau isolant.

3. Dispositif d'imagerie selon une quelconque revendication précédente, dans lequel chaque couche conductrice est constituée d'îlots d'un métal conducteur ayant une fréquence de plasma dans une gamme de longueurs d'onde ultraviolettes dans un agencement bidimensionnel à intervalles périodiques égaux ou inférieurs à ladite longueur d'onde électromagnétique effective.

4. Dispositif d'imagerie selon une quelconque revendication précédente, dans lequel la longueur d'onde électromagnétique détectée dans la couche de conversion photoélectrique a une longueur d'onde plus longue que les longueurs d'onde rouges, et dans lequel chaque couche conductrice est constituée d'îlots d'un métal conducteur ayant une fréquence de plasma dans une gamme de longueurs d'onde visibles dans un agencement bidimensionnel à intervalles périodiques égaux ou inférieurs à la longueur d'onde électromagnétique détectée.

5. Dispositif d'imagerie selon une quelconque revendication précédente, dans lequel les intervalles périodiques prédéterminés des couches conductrices formant la couche de structure conductrice sont fixés en réponse aux longueurs d'onde électromagnétique détectées par des dispositifs respectifs parmi les dispositifs de conversion photoélectrique agencés de la manière planaire dans la couche de conversion photoélectrique.

6. Appareil d'imagerie comportant le dispositif d'imagerie d'une quelconque revendication précédente.
